# EUROPÄISCHE PATENTSCHRIFT

(11) **EP 1 191 594 B1**
(45) Veröffentlichungstag und Bekanntmachung des Hinweises auf die Patenterteilung: **27.12.2006**
(21) Anmeldenummer: 01121302.2
(22) Anmeldetag: 05.09.2001
(51) Int. Cl.: H01L 27/08

(54) **Diodenvorrichtung aus zwei monolithisch miteinander integrierten Dioden**
Diode device comprising two monolithically integrated diodes
Dispositif de diode comprenant deux diodes monolithiquement intégrés

(30) Priorität: 21.09.2000 DE 10046936
(43) Veröffentlichungstag der Anmeldung: 27.03.2002
(73) Patentinhaber: Infineon Technologies AG, 81669 München (DE)
(72) Erfinder: Griebl, Erich, Dr., 84405 Dorfen (DE); Kapels, Holger, 83607 Holzkirchen (DE); Mauder, Anton, Dr., 83059 Kolbermoor (DE); Rupp, Roland, Dr., 91207 Lauf (DE); Willmeroth, Armin, 86163 Augsburg (DE)
(74) Vertreter: Müller - Hoffmann & Partner

(56) Entgegenhaltungen:
- EP-A- 0 020 233
- EP-A- 0 776 028
- US-A- 4 017 882
- US-A- 5 969 400
- PATENT ABSTRACTS OF JAPAN Bd. 1998, Nr. 04, 31. März 1998 (1998-03-31) & JP 9 321321 A (FUJI ELECTRIC CO LTD), 12. Dezember 1997 (1997-12-12)

## Beschreibung

Die vorliegende Erfindung betrifft eine Diodenvorrichtung aus zwei monolithisch miteinander integrierten Dioden, von denen die eine Diode hinsichtlich ihrer Schalteigenschaften und die andere Diode hinsichtlich ihrer Durchlasseigenschaften im Hochstrombetrieb optimiert sind, wobei die andere Diode erst bei außerhalb des normalen Betriebsbereiches der Diodenvorrichtung liegenden Stromdichten des angelegten Stroms zuschaltet, bei der die eine Diode eine anodenseitige, schwach dotierte Zone des einen Leitungstyps, eine kathodenseitige, schwach dotierte Driftzone des anderen, zum einen Leitungstyp entgegengesetzten Leitungstyps, die mit der schwach dotierten Zone des einen Leitungstyps einen pn-Übergang bildet, einen an eine Anodenmetallisierung angrenzenden und in der schwach dotierten Zone des einen Leitungstyps vorgesehenen stark dotierten Anodenemitter des einen Leitungstyps und eine Kathodenmetallisierung aufweist. Solche, außerhalb des normalen Betriebsbereiches liegende Stromdichten treten beispielsweise bei nicht repetitiven Betriebsfällen, wie beispielsweise einem Kurzschluss oder Einschaltstromspitzen, auf.

Dioden mit einer p⁺n⁻n-Schichtenfolge, die für schnelle Schaltvorgänge geeignet sind, also sogenannte schnelle Dioden, sollten in ihrem n⁻-leitenden Gebiet nur eine begrenzte Überschwemmungsladung aufweisen, so dass infolge dieser geringen Ladung die Speicherladung und damit die Schaltverluste begrenzt sind. Zur Erreichung dieses Ziels wird in bevorzugter Weise der Anodenemitter auf der Vorderseite der Diode abgeschwächt. Dieses Vorgehen mit einem schwächeren Anodenemitter hat aber den Nachteil, dass die Überstromfestigkeit der Diode verschlechtert wird.

Die obige Problematik, nach welcher eine für die Schnelligkeit der Diode notwendige begrenzte Überschwemmungsladung eine Verminderng der Überstromfestigkeit der Diode nach sich zieht, wird bisher entweder durch einen Kompromiss zwischen diesen beiden sich widersprechenden Forderungen hinsichtlich Überschwemmungsladung und Überstromfestigkeit oder durch Parallelschalten von zwei unterschiedlich optimierten Dioden gelöst (vgl. hierzu auch US 5,063,428). Bei dieser Parallelschaltung ist eine Diode für schnelles Schalten, also hinsichtlich ihrer Überschwemmungsladung, optimiert, während die andere Diode sich durch gute Durchlasseigenschaften auszeichnet, also eine hohe Überstromfestigkeit hat.

Es hat sich nun aber gezeigt, dass bei einer solchen Parallelschaltung die durchlassoptimierte Diode bei höheren Stromdichten bereits im normalen Betriebsbereich mit der Injektion von Ladungsträgern in das n⁻-leitende Gebiet beginnt, wodurch sich die Schalteigenschaften bei steigender Stromdichte graduell verschlechtern, so dass die Schnelligkeit beeinträchtigt wird.

Weiterhin offenbaren die US-A-4,017,882 und die US-A-5,969,400 jeweils eine Diode mit einer anodenseitigen, schwach dotierten Zone des einen Leitungstyps, einer kathodenseitigen, schwach dotierten Driftzone des anderen, zum einen Leitungstyp entgegengesetzten Leitungstyps, die mit der schwach dotierten Zone des einen Leitungstyps einen pn-Übergang bildet, einem an eine Anodenmetallisierung angrenzenden und in der schwach dotierten Zone des einen Leitungstyps vorgesehenen stark dotierten Anodenemitter des einen Leitungstyps und einer Kathodenmetallisierung. Die andere Diode hat eine in eine schwach dotierte Zone des anderen Leitungstyps eingebettete erste wannenförmige, stark dotierte Zone des einen Leitungstyps und eine in die erste wannenförmige Zone eingebettete zweite wannenförmige, stark dotierte Zone des anderen Leitungstyps. Die schwach dotierte Zone des einen Leitungstyps ist im Vergleich zu dem eine hohe Oberflächenkonzentration, aber eine geringe Eindringtiefe aufweisenden Anodenemitter niedrig dotiert, und zwischen der Driftzone und der Kathodenmetallisierung ist eine Zone des anderen Leitungstyps vorgesehen. In der US-A-5,969,400 ist zudem die andere Diode in die eine Diode eingelagert.

Es ist Aufgabe der vorliegenden Erfindung, eine Diodenvorrichtung aus zwei monolithisch miteinander integrierten Dioden zu schaffen, bei welcher eine Verschlechterung der Schalteigenschaften mit steigender Stromdichte vermieden wird.

Diese Aufgabe wird bei einer Diodenvorrichtung der eingangs genannten Art erfindungsgemäß dadurch gelöst, dass die andere Diode eine an eine schwach dotierte Zone des anderen Leitungstyps angrenzende erste wannenförmige, stark dotierte Zone des einen Leitungstyps und eine in der Oberfläche der ersten wannenförmigen Zone vorgesehene zweite wannenförmige, stark dotierte Zone des anderen Leitungstyps aufweist, und die erste wannenförmige Zone an ihrer Oberfläche von einer Isolierschicht abgedeckt ist, so dass ein Kurzschluss zwischen dem Anodenemitter und der zweiten wannenförmigen Zone ausgeschlossen ist.

Bei der erfindungsgemäßen Diodenvorrichtung werden also auf einem Chip zwei Dioden monolithisch miteinander integriert, so dass auf diesem Chip zwei Bereiche bestehen, von denen jeder jeweils einer Diode zugeordnet ist.

Bei der einen Diode in dem einen Bereich handelt es sich um eine dynamisch optimierte Diode, wie sie grundsätzlich bereits in der nicht vorveröffentlichten DE-A-100 31 461 beschrieben ist. Diese Diode besitzt die übliche Schwellspannung (Einsatzspannung) eines pn-Überganges in Silizium von etwa 0,5 ... 0,7 V und weist einen vergleichsweise hohen differenziellen Bahnwiderstand von etwa (1 ... 10 mΩ)/cm², vorzugsweise 5 mΩ/cm² aktiver Chipfläche bei einer Sperrspannung von 1200 V auf. Für höhere und niedrigere Sperrspannungen wird der Bahnwiderstand ebenfalls höhere bzw. niedrigere Werte annehmen. Dabei hat für beispielsweise 600 V dieser Bahnwiderstand nur etwa ein Viertel des oben angegebenen Wertes. Bei Bedarf kann in diesem Bereich der einen Diode auch eine Verringerung der Ladungsträger-Lebensdauer durch Diffusion oder Einbringung von beispielsweise Platin angewandt werden.

Die andere Diode, die in dem vorzugsweise aus Silizium bestehenden Chip in einem zweiten Bereich parallel zu der einen Diode liegt, hat eine hohe Schwellspannung, aber einen sehr niedrigen differenziellen Bahnwiderstand. Hierzu ist ein Anodenemitter mit hoher Emitterwirkung vorteilhaft. Vorzugsweise liegt die Schwellspannung der anderen Diode so hoch, dass erst oberhalb des normalen Betriebsbereiches dieser Diode, also beispielsweise ab dem drei- bis vierfachem Nennstrom, ein Stromfluss einsetzt. Ein geeigneter Wert für die Schwellspannung liegt damit bei etwa 3 ... 5 V.

Die Grundstruktur dieser anderen Diode ist in der nicht vorveröffentlichten DE-A 100 17 922 beschrieben. Diese andere Diode soll im Folgenden auch als Schutzdiode bezeichnet werden.

Die erfindungsgemäße Diodenvorrichtung kombiniert in vorteilhafter Weise eine dynamisch optimierte Diode (eine Diode; vgl. auch DE-A-100 31 461) mit einer Schutzdiode (andere Diode; vgl. auch DE-A 100 17 922). Im unten beschriebenen Ausführungsbeispiel liegt die Schutzdiode in der Mitte der dynamisch optimierten Diode. Das heißt, die Schutzdiode ist hier von der dynamisch optimierten Diode umgeben. Selbstverständlich ist aber die Lage der Schutzdiode nicht hierauf begrenzt. Vielmehr kann die Lage der Schutzdiode bezüglich der dynamisch optimierten Diode praktisch beliebig variiert werden.

Besonders vorteilhaft ist aber eine möglichst nahe Platzierung der Schutzdiode an späteren Kontakt- bzw. Bondstellen, damit hohe Spitzenströme nur wenig quer über die VorderseitenMetallisierung der Diodenvorrichtung zu fließen brauchen, sondern weitgehend direkt in den Chip abfließen können. Dadurch wird die Widerstandszähigkeit der Diodenvorrichtung gegen hohe Stoß-Stromspitzen deutlich verbessert, wie sie beispielsweise beim Einschalten von Geräten, in die die Diodenvorrichtung eingebaut ist, auftreten können.

Die erfindungsgemäße Diodenvorrichtung läßt sich einfach realisieren und benötigt im Vergleich zu einer herkömmlichen Freilaufdiode zur Definition ihrer p⁺- und n⁺-leitenden Gebiete lediglich eine zusätzliche Fotoebene, wie dies bei der folgenden Beschreibung eines Ausführungsbeispiels verdeutlicht wird. Im Einzelnen können in einem ersten Verfahrensabschnitt eine p⁻-leitende Wanne der durchlassoptimierten Diode und p⁺- sowie n⁺-leitende Gebiete der Schutzdiode implantiert und gegebenenfalls in ein oder mehreren Ofenschritten diffundiert werden.
In einem zweiten Verfahrensabschnitt kann sodann das p-leitende Anschlussgebiet für die p⁻-leitende Wanner der durchlassoptimierten Diode ebenfalls durch Implantation eingebracht werden. Die Dosis kann dabei gegebenenfalls so niedrig gewählt werden, dass die Implantation unmaskiert auch über dem n⁺-leitenden Gebiet der Schutzdiode erfolgen kann.

Von Bedeutung ist auf jeden Fall, dass kein direkter Kontakt zwischen dem p⁺-leitendem Gebiet der Schutzdiode und dem p-leitenden Anschlussgebiet oder der Anodenmetallisierung besteht. Um dies zu gewährleisten, wird eine Isolierschicht auf das p⁺-leitende Gebiet der Schutzdiode aufgebracht. Ein solcher direkter Kontakt von dem p⁺-leitenden Gebiet der Schutzdiode zu dem p-leitendem Anschlussgebiet der durchlassoptimierten Diode bzw. zu der Anodenmetallisierung würde nämlich das p⁺-leitende Gebiet der Schutzdiode als starken Emitter wirken lassen, was in einem Normalbetrieb der Diodenvorrichtung unerwünscht ist.

Die oben und im Folgenden angegebenen Leitfähigkeitstypen können bei Bedarf jeweils auch umgekehrt werden. Jedoch stellen die oben und im Ausführungsbeispiel für die einzelnen Gebiete bzw. Zonen gewählten Leitfähigkeitstypen eine bevorzugte Ausführungsform der Erfindung dar.

Nachfolgend wird die Erfindung anhand der Zeichnungen näher erläutert. Es zeigen:
- Fig. 1: ein Ausführungsbeispiel der erfindungsgemäßen Diodenvorrichtung mit einer dynamisch optimierten Diode I und einer Schutzdiode II mit hoher Schwellspannung;
- Fig. 2: eine dynamisch optimierte Diode und
- Fig. 3 bis Fig. 5: verschiedene Beispiele von Schutzdioden.

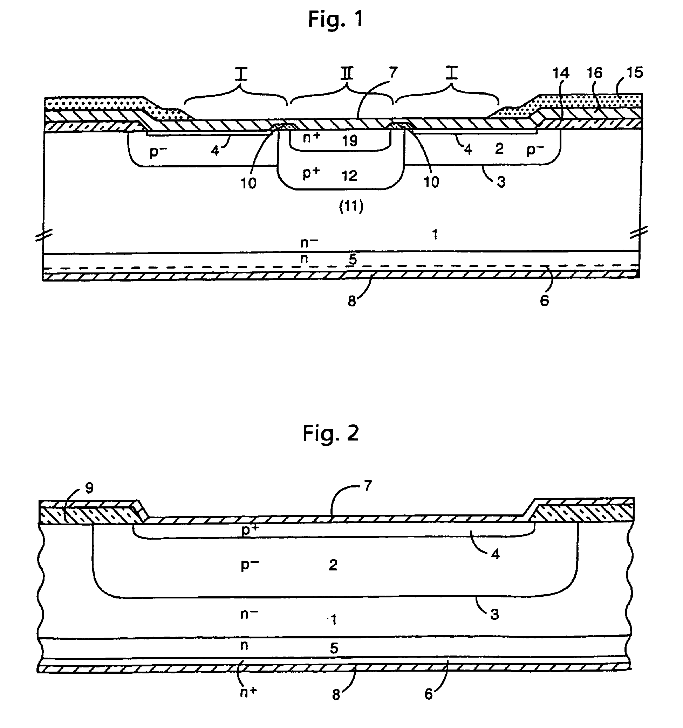

In Fig. 2 ist in einem schematischen Schnittbild eine dynamisch optimierte bzw. schaltoptimierte Hochvolt-Diode aus einem Siliziumkörper dargestellt. Anstelle von Silizium kann für die dynamisch optimierte Diode - was auch für die Schutzdiode gilt - ein anderes geeignetes Halbleitermaterial, wie beispielsweise SiC usw. gewählt werden. Dabei sollten die Dotierungskonzentrationen an das jeweilige Material angepasst sein.

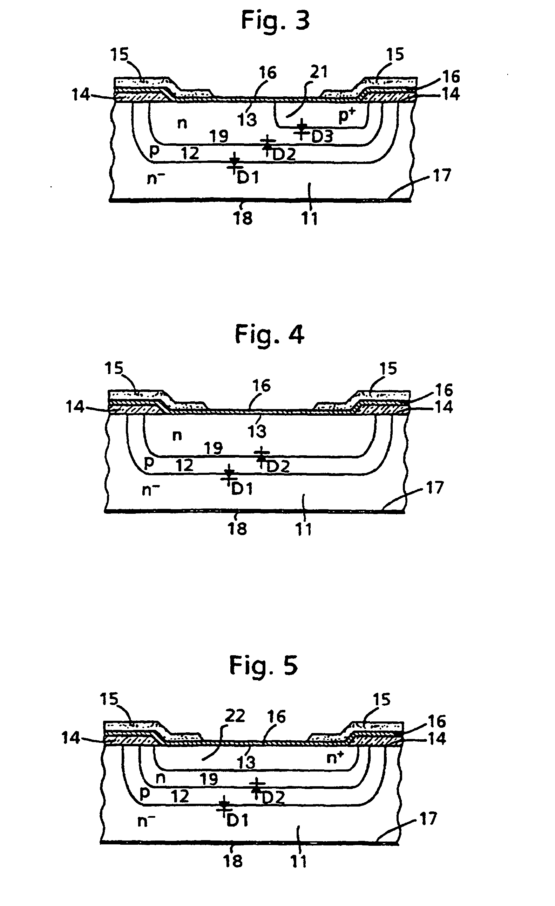

Die Diode von Fig. 2 weist eine n⁻-leitende Driftzone 1, eine p-leitende Zone 2, die mit der n⁻-leitenden Driftzone einen pn-Übergang 3 bildet, einen p⁺-leitenden Anodenemitter 4, eine n⁻-leitende Zone 5 und einen n⁺-leitenden Kathodenemitter 6 auf. Der Anodenemitter 4 ist mit einer Anodenmetallisierung 7 versehen, und auf dem Kathodenemitter 6 ist eine Kathodenmetallisierung 8 aufgetragen. Für diese Metallisierungen können bekannte Kontaktwerkstoffe, wie beispielsweise Al, AlSi usw. gewählt werden. Entsprechendes gilt auch für die Metallisierungen der Schutzdiode (vgl. Figuren 3 bis 5).

Die Dotierungsdosis in dem p+-leitenden Anodenemitter 4 wird zwischen 1,5 x 10¹² ... 5 x 10¹³ Atomen cm⁻² eingestellt. Vorzugsweise liegt die Dotierungsdosis zwischen 5 x 10¹² ... 2 x 10¹³ Atomen cm⁻². Der Anodenemitter 4 wird in bevorzugter Weise durch eine flache, oberflächennahe Implantation hergestellt, der sich ein Ausheilen ohne wesentliche Ausdiffusion des auf diese Weise implantierten Profils anschließt. Diese Ausdiffusion sollte nur soweit geschehen, dass die weiter oben angegebenen Werte für die Oberflächen-Dotierungskonzentration keinesfalls unterschritten werden. Mit anderen Worten, niedrigere Oberflächenkonzentrationen für den Anodenemitter 4 als 1 x 10¹⁷ Dotierstoffatome cm⁻³ sollten nicht eingestellt werden.

Zweckmäßigerweise wird die auf diese Weise implantierte Dosis lediglich aktiviert und dabei nur geringfügig um wenige nm ausdiffundiert. Die p-leitende Zone 2 kann in bevorzugter Weise mit einer Dosis von 1,3 x 10¹² bis 1,8 x 10¹² Dotierstoffatomen cm⁻² implantiert und mit einer Diffusionsweite von etwa zwei µm ausdiffundiert werden. Diese niedrige Dosis ist ausreichend, um für die p-leitende Zone 2 die gewünschte feldstoppende Wirkung zu erreichen. Gegebenenfalls können noch etwas höhere Werte als 1,8 x 10¹² Dotierstoffatome cm⁻² verwendet werden, was insbesondere dann gilt, wenn in der p-leitenden Zone 2 kleine Partikel oder Defekte vorhanden sind. So sind Werte von vorzugsweise 1,5 x 10¹² bis 3 x 10¹² Dotierstoffatomen cm⁻² sinnvoll. Bei der angegebenen Diffusionsweite von zwei µm ergibt sich eine mittlere Dotierungskonzentration in der Zone 2 von etwa 10¹⁶ Atomen cm⁻³.

Der Kathodenemitter 6 sollte einen ebenso einstellbaren, aber höheren Emitterwirkungsgrad als der Anodenemitter 4 aufweisen, um so eine stärkere, gezielte Anhebung von Ladungsträgern auf der Kathodenseite zu erreichen. In bevorzugter Weise werden so an der Oberfläche des Kathodenemitters 6 Donatorkonzentrationen über 10¹⁹ Atome cm⁻³ eingestellt, um einen Ohm'schen Kontakt zu der Kathodenmetallisierung 8, die beispielsweise aus Aluminium besteht, zu gewährleisten. Eine zweckmäßige Dosis für die Implantation des Kathodenemitters 6 liegt bei Werten von 5 x 10¹³ Dotierstoffatomen cm⁻² und darüber.

Der Emitterwirkungsgrad im Anodenemitter 4 bzw. im Kathodenemitter 6 kann durch oberflächennahe Kristallschäden reduziert werden. Solche Kristallschäden können durch Bestrahlungen oder Ionenimplantationen mit beispielsweise Argon oder Krypton oder dergleichen erreicht werden. Eine Verschlechterung der Sperreigenschaften der Hochvolt-Diode ist durch diese gezielten oberflächennahen Kristallschäden nicht zu erwarten, da die für das statische Sperren zuständigen Schichten der Zonen 2 und 5 nicht beeinflußt werden.

Die dynamisch optimierte Hochvolt-Diode von Fig. 2 ist in üblicher Weise mit Isolierschichten versehen, wie es beispielsweise in EP 0 341 453 B1 beschrieben ist. Als Beispiel für den Beginn eines möglichen Randabschlusses ist eine Isolierschicht 9 aus Siliziumdioxid auf der Anodenseite gezeigt. Anstelle von Siliziumdioxid kann auch ein anderes geeignetes Isoliermaterial, wie beispielsweise Siliziumnitrid, gewählt werden.

Fig. 3 zeigt eine Schutzdiode mit hoher Schwellspannung mit einem n⁻-leitenden Silizium-Halbleiterkörper 11, in den eine p-leitende Zone 12 beispielsweise durch Diffusion eingebracht ist. Zwischen dem n⁻-leitenden Silizium-Halbleiterkörper 11 und der p-leitenden Zone bildet sich so eine erste Diode D1.

In der p-leitenden Zone 2 ist eine n-leitende Zone 19 vorgesehen, so dass zwischen den Zonen 12 und 19 ein pn-Übergang einer zweiten Diode D2 entsteht.

In die n-leitende Zone 19 kann noch eine p⁺-leitende Schicht 21 eingebracht sein, die einen pn-Übergang einer Diode D3 mit der n-leitenden Zone 19 bildet. Diese p⁺-leitende Schicht 21 erniedrigt den Bahnwiderstand der Schutzdiode aus Fig. 2.

Auf einer ersten Oberfläche 13 des Halbleiterkörpers 11 bzw. der Zonen 12, 19 und der Schicht 21 befinden sich noch eine Rand-Oxidschicht 14, eine Polyimidschicht 15 und eine Metall-Kontaktschicht 16 aus beispielsweise Aluminium, während auf einer zur Oberfläche 13 gegenüberliegenden Oberfläche 17 des Halbleiterkörpers 11 ein unterer Abschluß 18 des Halbleiterkörpers vorgesehen ist. Dieser untere Abschluß 18 besteht auf jeden Fall aus einer Kathodenmetallisierung aus beispielsweise Aluminium und ist vorzugsweise entsprechend den Schichten 5, 6 und 8 von Fig. 2 aufgebaut. Die Diode D3 ist mit der Diode D1 in Flussrichtung gepolt, wenn die Diode D2 in Sperrrichtung angeordnet ist.

Da sich die Zone 19 bis unter die Metall-Kontaktschicht 16 erstreckt, wird ein großer Teil des Stroms an dem p-leitenden Emitter, also an der Schicht 21 vorbei in die Anode geführt. Dies bedeutet, dass erst bei hohen Stromdichten, die wesentlich oberhalb des Sperrstromniveaus der Diode D2 liegen, der pnp-Transistor aus den Zonen 12 und 19 sowie aus der Schicht 21 aufgesteuert wird. Das heißt, die sogenannte snap-back-Erscheinung verschiebt sich zu einem höheren Stromniveau.

Auf die Schicht 21 kann aber, wie in Fig. 4 gezeigt ist, verzichtet werden, so dass der Effekt dieses pnp-Transistors vollständig entfällt. Bei der Schutzdiode von Fig. 4 kann ein snap-back erst auftreten, wenn der npn-Transistor aus dem Siliziumkörper 11 und den Zonen 12 und 19 aufgesteuert wird. Durch eine geeignete Dimensionierung kann aber erreicht werden, dass eine solche snap-back-Erscheinung erst bei sehr hohen Stromdichten eintritt.

Schließlich zeigt Fig. 5 noch eine Abwandlung der Diode von Fig. 4: hier ist zusätzlich noch eine n⁺-leitende Schicht 22 vorgesehen, die zur besseren Kontaktgabe zu der Kontaktschicht 19 dient.

Die Dioden der Fig. 3 bis 5 besitzen bei hohen Stromdichten die besseren Durchlaßwerte als die dynamisch bzw. schaltoptimierte Diode von Fig. 2.

Die Schutzdiode besteht in bevorzugter Weise aus Silizium. Selbstverständlich können für diese Diode aber auch andere Halbleitermaterialien, wie beispielsweise SiC oder A_{III}B_{V}-Halbleitermaterialen gewählt werden, was im Übrigen auch für die schaltoptimierte Diode von Fig. 2 gilt. Ebenso können die jeweils angegebenen Leitfähigkeitstypen umgekehrt werden, das heißt, die p-Leitfähigkeit kann durch die n-Leitfähigkeit und umgekehrt ersetzt werden.

Fig. 1 zeigt eine Ausführungsbeispiel der erfindungsgemäßen Diodenvorrichtung mit einer dynamisch optimierten Diode I, die entsprechend der Diode von Fig. 2 ausgebildet ist, und einer Schutzdiode II mit hoher Schwellspannung, die entsprechend der Diode von Fig. 4 gestaltet ist.

Die dynamisch optimierte Diode I entspricht also der Diode von Fig. 2, wenn von dem Kathodenemitter 6 abgesehen wird (in Fig. 1 in Strichlinien eingezeichnet). Dieser Kathodenemitter 6 kann aber bei der erfindungsgemäßen Diodenvorrichtung auch vorhanden sein. In diesem Fall ist also dann zwischen der n-leitenden Zone 5 und der Kathodenmetallisierung 8 zusätzlich zu Fig. 1 noch der n⁺-leitende Kathodenemitter 6 von Fig. 2 vorgesehen.

Die Schutzdiode II kann bei dem Ausführungsbeispiel von Fig. 1 auch entsprechend der Diode von Fig. 3 oder von Fig. 5 aufgebaut sein. Das heißt, in der Schicht 19 kann noch die p⁺-leitende Zone 21 oder die n⁺-leitende Schicht 22 vorgesehen sein.

Im Ausführungsbeispiel von Fig. 1 liegt die Schutzdiode II in der Mitte der dynamisch optimierten Diode I. Mit anderen Worten, die dynamisch optimierte Diode I umgibt die Schutzdiode II.

Selbstverständlich kann auch eine andere Lagebeziehung zwischen der Schutzdiode II und der dynamisch optimierten Diode I bestehen. Beispielsweise kann die Schutzdiode II die dynamisch optimierte Diode I umgeben. Ebenso können die beiden Dioden II und I parallel nebeneinander in Streifenform vorgesehen werden.

Besonders vorteilhaft ist aber eine Platzierung der Schutzdiode II in möglichst großer Nähe an einer späteren Kontaktstelle, wie insbesondere einer Bondstelle, da dann hohe Spitzenströme nur wenig quer über eine Vorderseitenmetallisierung (Metallisierung 16) zu fließen brauchen, sondern vielmehr direkt von dieser Metallisierung in den diese Diode II bildenden Chip eindringen. Hierdurch wird die Widerstandsfähigkeit der Diodenvorrichtung gegenüber hohen Stoß-Stromspitzen, wie sie beim Einschalten von Geräten auftreten können, wesentlich verbessert.

Die dynamisch optimierte Diode I besitzt die übliche Schwellspannung eines pn-Überganges in Silizium von etwa 0,5 ... 0,7 V (vgl. den pn-Übergang 3) und einen vergleichsweise hohen differenziellen Bahnwiderstand von etwa 1 ... 10 mΩ (insbesondere 5mΩ) pro cm² aktiver Chipfläche. Diese Schwellspannung hängt vom Halbleitermaterial ab und hat beispielsweise für SiC andere Werte als 0,5 ... 0,7 V. Auch kann der differenzielle Bahnwiderstand für verschiedene Stromklassen und auch Optimierungsziele andere Werte annehmen. Durch Einbringen von beispielsweise Platin kann für eine Verringerung der Ladungsträger-Lebensdauer gesorgt werden. Weiterhin ist es möglich, den Emitterwirkungsgrad des Anodenemitters 4 durch oberflächennahe Kristallschäden, die durch Bestrahlung oder Ionenimplantation von Argon oder Krypton erzeugt sind, zu reduzieren.

Die p⁻-leitende Zone 2 der Diode I ist im Vergleich zu dem eine relativ hohe Oberflächenkonzentration, aber eine geringe Eindringtiefe aufweisenden p⁺-leitenden Anodenemitter 4 niedrig dotiert. So kann die Dotierstoff-Dosis des p⁺-leitenden Anodenemitters 4 zwischen 1,3 x 10¹² Dotierstoffatomen cm⁻² und 5 x 10¹³ Dotierstoffatomen cm⁻², insbesondere zwischen 5 x 10¹² Do-tierstoffatomen cm⁻² und 2 x 10¹³ Dotierstoffatomen cm⁻² liegen. Die implantierten Dotierstoffatome der p-leitenden Zone 2 können mit einer Diffusionsweite von etwa 2 µm ausdiffundiert sein. Der p⁺-leitende Anodenemitter kann mit einer Dosis von höchstens 2 x 10¹³ Dotierstoffatomen cm⁻² implantiert sein. Die an den pn-Übergang angrenzende p-leitende Zone 2 kann mit einer Dosis von (1,3 ... 3) x 10¹² Dotierstoffatomen cm⁻² dotiert sein.

Die Schutzdiode II weist eine hohe Schwellspannung und einen sehr niedrigen differenziellen Bahnwiderstand auf. Dabei liegt die Schwellspannung der Schutzdiode deutlich über der vom Bandabstand des Halbleitermaterials vorgegebenen Schwellspannung, welche bei Silizium etwa 0,5 V beträgt. Außerdem hat der Anodenemitter, also die Zone 19, eine hohe Emitterwirkung. Die Schwellspannung ist dabei so hoch, dass erst oberhalb des normalen Betriebsbereiches der Diode II, also beispielsweise ab dem drei- bis vierfachen Nennstrom ein merklicher Stromfluss in der Diode II einsetzt. Eine geeignete Schwellspannung der Diode II liegt so bei etwa 3 ... 5 V. Der differenzielle Bahnwiderstand der Schutzdiode II ist mindestens um einen Faktor 5 und vorzugsweise um einen Faktor 10 niedriger als der differenzielle Bahnwiderstand der Diode I.

Dadurch ist sichergestellt, daß die Diode II erst bei außerhalb des normalen Betriebsbereichs der Diodenvorrichtung liegenden Stromdichten des an die Diode II gelegten Stromes zu- bzw. einschaltet.

Von großer Bedeutung ist, dass kein direkter Kontakt zwischen der p⁺-leitenden Zone 12 einerseits und dem p⁺-leitenden Anodenemitter 4 und der Metallisierung 16 andererseits besteht. Um dies zu gewährleisten, ist eine Isolierschicht 10 aus beispielsweise Siliziumdioxid oder Siliziumnitrid auf der Oberfläche der Zone 12 vorgesehen.

Fig. 1 zeigt noch ähnlich wie die Figuren 3 bis 5 eine Randisolierschicht 14 aus vorzugsweise ebenfalls Siliziumdioxid oder Siliziumnitrid und eine Polyimidschicht 15, die im Randbereich auf der Aluminium-Metallisierung 16 vorgesehen ist.

Für den p-leitenden Dotierstoff kann in üblicher Weise Bor verwendet werden, während ein geeigneter n-leitender Dotierstoff beispielsweise Phosphor ist.

Die Herstellung der erfindungsgemäßen Diodenvorrichtung benötigt im Vergleich zu einer Freilaufdiode lediglich eine weitere Fotoebene zur Definition der p⁺-leitenden Zonen 4 und 12 und der n⁺-leitenden Zone 19. In einem konkreten Verfahren werden in einem ersten Schritt zunächst die p⁻-leitende Zone 2 sowie die p⁺-leitende Zone 12 und die n⁺-leitende Zone 19 implantiert. An diese Implantationen können sich ein oder mehrere Ofenschritte zur Diffusion des implantierten Dotierstoffes speziell für die Zonen 12 und 19 anschließen. Für den p⁺-leitenden Anodenemitter 4 ist eine weite Ausdiffusion unerwünscht. Dagegen sollten die Zonen 12 und 19 ausdiffundiert werden, da sie einen direkten Kontakt der Metallisierung 16 mit den darunter liegenden Schichten auch bei kleinen lokalen Defekten in der Implantation verhindern müssen. In einem zweiten Verfahrensschritt wird sodann der p⁺-leitende Anodenemitter 4 in die p⁻-leitende Zone 2 durch Implantation eingebracht. Die Dosis kann dabei gegebenenfalls so niedrig gewählt werden, dass die Implantation unmaskiert auch über der n+-leitenden Zone 19 vorgenommen werden kann.

In den oben angegebenen Ausführungsbeispielen können die angegebenen Leitungstypen auch jeweils vertauscht werden. Im Beispiel von Fig. 2 können also die Zonen 1, 5 und 6 p⁻-, p- und p⁺-leitend und die Zonen 2 und 4 n⁻ - und n⁺-leitend sein. Entsprechendes gilt auch für die übrigen Ausführungsbeispiele.

## Patentansprüche

1. Diodenvorrichtung aus zwei monolithisch miteinander integrierten Dioden (I, II), von denen die eine Diode (I) hinsichtlich ihrer Schalteigenschaften und die andere Diode (II) hinsichtlich ihrer Durchlasseigenschaften im Hochstrombetrieb optimiert sind, wobei die andere Diode (II) erst bei ausserhalb des normalen Betriebsbereiches der Diodenvorrichtung liegenden Stromdichten des angelegten Stroms zuschaltet, bei der:
- die eine Diode (I) eine anodenseitige, schwach dotierte Zone (2) des einen Leitungstyps, eine kathodenseitige, schwach dotierte Driftzone (1) des anderen, zum einen Leitungstyp entgegengesetzten Leitungstyps, die mit der schwach dotierten Zone (2) des einen Leitungstyps einen pn-Übergang (3) bildet, einen an eine Anodenmetallisierung (7) angrenzenden und in der schwach dotierten Zone (2) des einen Leitungstyps vorgesehenen stark dotierten Anodenemitter (4) des einen Leitungstyps und eine Kathodenmetallisierung (8) aufweist,
**dadurch gekennzeichnet,**
**dass**
- die andere Diode (II) eine an eine schwach dotierte Zone (11) des anderen Leitungstyps angrenzende erste wannenförmige, stark dotierte Zone (12) des einen Leitungstyps und eine in der Oberfläche der ersten wannenförmigen Zone (12) vorgesehene zweite wannenförmige, stark dotierte Zone (19) des anderen Leitungstyps aufweist, und
- die erste wannenförmige Zone (12) an ihrer Oberfläche von einer Isolierschicht (10) abgedeckt ist, so dass ein Kurzschluss zwischen dem Anodenemitter (4) und der zweiten wannenförmige Zone (12) ausgeschlossen ist.

2. Diodenvorrichtung nach Anspruch 1,
**dadurch gekennzeichnet,**
**dass** der differenzielle Bahnwiderstand der einen Diode (I) 1 ... 10 mΩ, insbesondere 5 mΩ, pro cm² aktiver Oberfläche eines die Diodenvorrichtung bildenden Chips für eine Sperrspannung von 1200 V beträgt.

3. Diodenvorrichtung nach Anspruch 1 oder 2,
**dadurch gekennzeichnet,**
**dass** die Schwellspannung des pn-Obergangs der anderen Diode (II) deutlich über der vom Bandabstand eines für die Diodenvorrichtung verwendeten Halbleitermaterials vorgegebenen Schwellspannung, insbesondere für Silizium 0,5 ... 0,7 V, liegt und 3 ... 5 V beträgt.

4. Diodenvorrichtung nach einem der Ansprüche 1 bis 3,
**dadurch gekennzeichnet,**
**dass** der differenzielle Bahnwiderstand der anderen Diode (II) um mindestens einen Faktor 5 und vorzugsweise um einen Faktor 10 niedriger ist als der differenzielle Bahnwiderstand der einen Diode (I).

5. Diodenvorrichtung nach einem der Ansprüche 1 bis 4,
**dadurch gekennzeichnet,**
- **dass** die schwach dotierte Zone (2) des einen Leitungstyps im Vergleich zu dem eine hohe Oberflächenkonzentration, aber eine geringe Eindringtiefe aufweisenden Anodenemitter (4) niedrig dotiert ist,
- **dass** zwischen der Driftzone (1) und der Kathodenmetallisierung (8) eine Zone (5) des anderen Leitungstyps vorgesehen ist,
- **dass** die Dotierstoffdosis des Anodenemitters (4) zwischen 1,3 x 10¹² Dotierstoffatomen cm⁻² und 5 x 10¹³ Dotierstoffatomen cm⁻² liegt, und
- **dass** die an den pn-Übergang (3) angrenzende schwach dotierte Zone (2) des einen Leitungstyps mit einer Dosis von (1,3 ... 3) x 10¹² Dotierstoffatomen cm⁻² dotiert ist.

6. Diodenvorrichtung nach einem der Ansprüche 1 bis 5,
**dadurch gekennzeichnet,**
**dass** die Dotierstoffdosis des Anodenemitters (4) zwischen 5 x 10¹² Dotierstoffatomen cm⁻² und 2 x 10¹³ Dotierstoffatomen cm⁻² liegt.

7. Diodenvorrichtung nach einem der Ansprüche 1 bis 6,
**dadurch gekennzeichnet,**
**dass** die implantierten Dotierstoffatome der schwach dotierten Zone (2) des einen Leitungstyps mit einer Diffusionsweite von 2*µ*m ausdiffundiert sind.

8. Diodenvorrichtung nach einem der Ansprüche 1 bis 7,
**dadurch gekennzeichnet,**
**dass** der Anodenemitter (4) mit einer Dosis von höchstens 2 x 10¹³ Dotierstoffatomen cm⁻² implantiert ist.

9. Diodenvorrichtung nach einem der Ansprüche 1 bis 8,
**dadurch gekennzeichnet,**
**dass** der Emitterwirkungsgrad des Anodenemitters (4) durch oberflächennahe Kristallschäden reduziert ist.

10. Diodenvorrichtung nach einem der Ansprüche 1 bis 9,
**dadurch gekennzeichnet,**
**dass** in die eine Diode (I) zur Verringerung der Ladungsträger-Lebensdauer durch Diffusion Platin eingebracht ist.

11. Diodenvorrichtung nach einem der Ansprüche 1 bis 10,
**dadurch gekennzeichnet,**
**dass** die andere Diode (II) in die eine Diode (I) eingelagert ist.

12. Diodenvorrichtung nach einem der Ansprüche 1 bis 11,
**dadurch gekennzeichnet,**
**dass** die andere Diode (II) möglichst nahe an einer Kontaktstelle (vgl. 16) eines äußeren Kontakts gelegen ist.

13. Diodenvorrichtung nach einem der Ansprüche 1 bis 12,
**dadurch gekennzeichnet,**
**dass** die Anode der anderen Diode (II) derart gestaltet ist, dass ein im Anodenbereich gebildeter Transistor mit einem Kanal des einen Leitungstyps nicht oder erst bei hohen Stromdichten oberhalb des Sperrstromniveaus des aus der ersten und zweiten wannenförmigen Zone (12, 19) gebildeten pn-Überganges (D2) aufsteuert und bei niedrigen Stromdichten keine Wirkung entfaltet.

14. Diodenvorrichtung nach einem der Ansprüche 1 bis 13,
**dadurch gekennzeichnet,**
**dass** Gebiete des anderen Leitungstyps und eine dritte, stark dotierte Zone (21) des einen Leitungstyps in der zweiten wannenförmigen Zone (19) enthalten sind,

15. Diodenvorrichtung nach Anspruch 14,
**dadurch gekennzeichnet,**
**dass** die Anodenmetallisierung (16) zusätzlich zu der dritten Zone (21) auch die zweite wannenförmige Zone (19) kontaktiert.

16. Diodenvorrichtung nach Anspruch 13,
**dadurch gekennzeichnet,**
**dass** die Anode aus lediglich der zweiten wannenförmige Zone (19) gebildet ist.

17. Diodenvorrichtung nach Anspruch 16,
**dadurch gekennzeichnet,**
**dass** die zweite wannenförmige Zone (19) einen stark dotierten Kontaktbereich (22) des anderen Leitungstyps enthält.

18. Diodenvorrichtung nach einem der Ansprüch 1 bis 17,
**dadurch gekennzeichnet,**
**dass** die Driftzone (1) und die Zone (11) des anderen Leitungstyps dasselbe Gebiet sind.

19. Diodenvorrichtung nach einem der Ansprüche 1 bis 18,
**dadurch gekennzeichnet,**
**dass** der eine Leitungstyp der p-Leitungstyp ist.

## Claims

1. Diode device made of two diodes (I, II) monolithically integrated together, of which the one diode (I) is optimised with regard to its switching characteristics, and the other diode (II) is optimised with regard to its forward characteristics during high-current operation, where the other diode (II) does not switch on until current densities of the applied current lie outside the normal operating range of the diode device, in which:
- the one diode (I) comprises an anode-side, lightly doped region (2) of the one conduction type, a cathode-side, lightly doped drift region (1) of the other conduction type, which is opposite to the one conduction type, forming a pn-junction (3) with the lightly doped region (2) of the one conduction type, a heavily doped anode emitter (4) of the one conduction type, which is provided in the lightly doped region (2) of the one conduction type and adjoins an anode metallisation (7), and a cathode metallisation (8),
**characterised in that**
- the other diode (II) has a first well-shaped, heavily doped region (12) of the one conduction type adjoining a lightly doped region (11) of the other conduction type, and a second well-shaped, heavily doped region (19) of the other conduction type provided in the surface of the first well-shaped region (12), and
- the first well-shaped region (12) is covered on its surface by an insulating layer (10) so that a short-circuit cannot occur between the anode emitter (4) and the second well-shaped region (12).

2. Diode device according to Claim 1,
**characterised in that**
the differential bulk resistance of the one diode (I) equals 1 to 10 mΩ, in particular 5 mΩ, per cm² of active chip area of a chip forming the diode device for a reverse voltage of 1200 V.

3. Diode device according to Claim 1 or 2,
**characterised in that**
the threshold voltage of the pn-junction of the other diode (II) lies well above the threshold voltage given by the bandgap of a semiconductor material used for the diode device, in particular 0.5 to 0.7 V for silicon, and equals 3 to 5 V.

4. Diode device according to any of Claims 1 to 3,
**characterised in that**
the differential bulk resistance of the other diode (II) is lower than the differential bulk resistance of the one diode (I) at least by a factor of 5 and preferably by a factor of 10.

5. Diode device according to any of Claims 1 to 4,
**characterised in that**
- the lightly doped region (2) of the one conduction type is doped at a low level compared with the anode emitter (4) having a high surface concentration but a low penetration depth,
- a region (5) of the other conduction type is provided between the drift region (1) and the cathode metallisation (8),
- the dopant dose of the anode emitter (4) lies between 1.3 x 10¹² dopant atoms cm⁻² and 5 x 10¹³ dopant atoms cm⁻², and
- the lightly doped region (2) of the one conduction type adjacent to the pn-junction (3) is implanted with a dose of (1.3 to 3) x 10¹² dopant atoms cm⁻².

6. Diode device according to any of Claims 1 to 5,
**characterised in that**
the dopant dose of the anode emitter (4) lies between 5 x 10¹² dopant atoms cm⁻² and 2 x 10¹³ dopant atoms cm⁻².

7. Diode device according to any of Claims 1 to 6,
**characterised in that**
the implanted dopant atoms of the lightly doped region (2) of the one conduction type are diffused out by a diffusion distance of 2*µ*m.

8. Diode device according to any of Claims 1 to 7,
**characterised in that**
the anode emitter (4) is implanted with a dose of 2 x 10¹³ dopant atoms cm⁻² maximum.

9. Diode device according to any of Claims 1 to 8,
**characterised in that**
the emitter efficiency of the anode emitter (4) is reduced by superficial crystal damage.

10. Diode device according to any of Claims 1 to 9,
**characterised in that**
platinum is introduced by diffusion into the one diode (I) to reduce the charge carrier lifetime.

11. Diode device according to any of Claims 1 to 10,
**characterised in that**
the other diode (II) is embedded in the one diode (I).

12. Diode device according to any of Claims 1 to 11,
**characterised in that**
the other diode (II) is placed as close as possible to a contact point (cf. 16) of an external contact.

13. Diode device according to any of Claims 1 to 12,
**characterised in that**
the anode of the other diode (II) is designed such that a transistor formed in the anode area having a channel of the one conduction type is not driven on at all or not until high current densities exist above the reverse-current level of the pn-junction (D2) formed from the first and second well-shaped region (12, 19), and produces no effect at low current densities.

14. Diode device according to any of Claims 1 to 13,
**characterised in that**
regions of the other conduction type and a third heavily doped region (21) of the one conduction type are contained in the second well-shaped region (19).

15. Diode device according to Claim 14,
**characterised in that**
the anode metallisation (16) also makes contact with the second well-shaped region (19) in addition to the third region (21).

16. Diode device according to Claim 13,
**characterised in that**
the anode is formed solely from the second well-shaped region (19).

17. Diode device according to Claim 16,
**characterised in that**
the second well-shaped region (19) contains a heavily doped contact region (22) of the other conduction type.

18. Diode device according to any of Claims 1 to 17,
**characterised in that**
the drift region (1) and the region (11) of the other conduction type are the same region.

19. Diode device according to any of Claims 1 to 18,
**characterised in that**
the one conduction type is the p-conduction type.

## Revendications

1. Dispositif de diodes composé de deux diodes (I, II) intégrées ensemble de façon monolithique, l'une des diodes (I) étant optimisée au niveau de ses propriétés de commutation et l'autre (II) au niveau de ses propriétés à l'état passant lors d'un fonctionnement avec un courant de forte intensité, la deuxième diode (II) n'étant mise en circuit qu'en présence de densités du courant appliqué qui se trouvent en dehors de la plage de fonctionnement normale du dispositif de diodes,
- la première diode (I) comportant une zone (2) côté anode qui est faiblement dopée et d'un premier type de conductivité, une zone de dérive (1) côté cathode qui est faiblement dopée et de l'autre type de conductivité opposé au premier type de conductivité et qui forme avec la zone faiblement dopée (2) du premier type de conductivité une jonction pn (3), un émetteur anodique (4) qui est fortement dopé et du premier type de conductivité, qui est adjacent à une métallisation anodique (7) et qui est prévu dans la zone faiblement dopée (2) du premier type de conductivité et une métallisation cathodique (8),
**caractérisé par le fait que**
- la deuxième diode (II) comporte une première zone fortement dopée (12), en forme de cuve et du premier type de conductivité, qui est adjacente à une zone faiblement dopée (11) du deuxième type de conductivité et une deuxième zone fortement dopée (19), en forme de cuve et du deuxième type de conductivité, qui est prévue dans la surface de la première zone (12) en forme de cuve, et
- la première zone (12) en forme de cuve est recouverte sur sa surface par une couche isolante (10) de telle sorte qu'un court-circuit entre l'émetteur anodique (4) et la deuxième zone (12) en forme de cuve est exclu.

2. Dispositif de diodes selon la revendication 1,
**caractérisé par le fait que** la résistance de volume différentielle de la première diode (I) vaut 1 à 10 mΩ, de préférence 5 mΩ, par cm² de surface active d'une puce formant le dispositif de diodes pour une tension de blocage de 1 200 V.

3. Dispositif de diodes selon la revendication 1 ou 2,
**caractérisé par le fait que** la tension de seuil de la jonction pn de l'autre diode (II) est nettement supérieure à la tension de seuil prescrite par l'intervalle de bande d'un matériau semi-conducteur utilisé pour le dispositif à diodes, notamment 0,5 à 0,7 V pour du silicium, et vaut de 3 à 5 V.

4. Dispositif de diodes selon l'une des revendications 1 à 3,
**caractérisé par le fait que** la résistance de volume différentielle de la deuxième diode (II) est inférieure d'au moins un facteur 5 et de préférence d'un facteur 10 à la résistance de volume différentielle de la première diode (I).

5. Dispositif de diodes selon l'une des revendications 1 à 4,
**caractérisé par le fait que**
- la zone faiblement dopée (2) du premier type de conductivité est faiblement dopée en comparaison de l'émetteur anodique (4) qui a une grande concentration de surface mais une petite profondeur de pénétration,
- une zone (5) du deuxième type de conductivité est prévue entre la zone de dérive (1) et la métallisation cathodique (8),
- le dosage de dopant de l'émetteur anodique (4) est compris entre 1,3 x 10¹² et 5 x 10¹³ atomes de dopant cm⁻², et
- la zone faiblement dopée (2) du premier type de conductivité et adjacente à la jonction pn (3) est dopée avec un dosage de (1,3 à 3) x 10¹² atomes de dopant cm⁻².

6. Dispositif de diodes selon l'une des revendications 1 à 5,
**caractérisé par le fait que** le dosage de dopant de l'émetteur anodique (4) est compris entre 5 x 10¹² et 2 x 10¹³ atomes de dopant cm⁻².

7. Dispositif de diodes selon l'une des revendications 1 à 6,
**caractérisé par le fait que** les atomes de dopant implantés de la zone faiblement dopée (2) du premier type de conductivité sont diffusés vers l'extérieur avec une largeur de diffusion de 2 µm.

8. Dispositif de diodes selon l'une des revendications 1 à 7,
**caractérisé par le fait que** l'émetteur anodique (4) est implanté avec un dosage maximal de 2 x 10¹³ atomes de dopant cm⁻².

9. Dispositif de diodes selon l'une des revendications 1 à 8,
**caractérisé par le fait que** le degré d'action émettrice de l'émetteur anodique (4) est réduit par des défauts cristallins proches de la surface.

10. Dispositif de diodes selon l'une des revendications 1 à 9,
**caractérisé par le fait que** du platine est introduit par diffusion dans la première diode (I) pour réduire la durée de vie de porteurs de charges.

11. Dispositif de diodes selon l'une des revendications 1 à 10,
**caractérisé par le fait que** la deuxième diode (II) est placée dans la première diode (I).

12. Dispositif de diodes selon l'une des revendications 1 à 11,
**caractérisé par le fait que** la deuxième diode (II) est placée le plus près possible d'un point de contact (cf. 16) d'un contact exérieur.

13. Dispositif de diodes selon l'une des revendications 1 à 12,
**caractérisé par le fait que** l'anode de la deuxième diode (II) est conçue de telle sorte qu'un transistor formé dans la zone anodique avec un canal du premier type de conductivité n'est pas commandé pour être conducteur ou alors seulement pour de grandes densités de courant au-dessus du niveau de courant à l'état bloqué de la jonction pn (D2) formée de la première et de la deuxième zone en forme de cuve (12, 19) et qu'il n'a aucune action pour de petites densités de courant.

14. Dispositif de diodes selon l'une des revendications 1 à 13,
**caractérisé par le fait que** des régions du deuxième type de conductivité et une troisième zone fortement dopée (21) du premier type de conductivité sont contenues dans la deuxième zone en forme de cuve (19).

15. Dispositif de diodes selon la revendication 14,
**caractérisé par le fait que** la métallisation anodique (16) établit un contact non seulement avec la troisième zone (21) mais aussi avec la deuxième zone en forme de cuve (19).

16. Dispositif de diodes selon la revendication 13,
**caractérisé par le fait que** l'anode est formée simplement de la deuxième zone en forme de cuve (19).

17. Dispositif de diodes selon la revendication 16,
**caractérisé par le fait que** la deuxième zone en forme de cuve (19) contient une zone de contact fortement dopée (22) du deuxième type de conductivité.

18. Dispositif de diodes selon l'une des revendications 1 à 17,
**caractérisé par le fait que** la zone de dérive (1) et la zone (11) du deuxième type de conductivité sont la même région.

19. Dispositif de diodes selon l'une des revendications 1 à 18,
**caractérisé par le fait que** le premier type de conductivité est le type p.
